# EUROPEAN PATENT SPECIFICATION

(11) **EP 2 068 373 B1**
(45) Date of publication and mention of the grant of the patent: **07.12.2016**
(21) Application number: 07807630.4
(22) Date of filing: 20.09.2007
(51) Int. Cl.: H01L 31/042, H01L 31/0216

(54) **SOLAR CELL MODULE**
SOLARZELLENMODUL
MODULE DE PILE SOLAIRE

(30) Priority: 29.09.2006 JP 2006269254
(43) Date of publication of application: 10.06.2009
(73) Proprietor: Panasonic Intellectual Property Management Co., Ltd., Osaka-shi, Osaka 540-6207 (JP)
(72) Inventor: NAKASHIMA, Takeshi, c/o Sanyo Electric Co., Ltd., 2-chome, Moriguchi City, Osaka 570-8677 (JP); MARUYAMA, Eiji c/o Sanyo Electric Co., Ltd., 2-chome, Moriguchi City, Osaka 570-8677 (JP)
(74) Representative: Addiss, John William
(86) International application number: PCT/JP2007/068266
(87) International publication number: WO 2008/041489

(56) References cited:
- EP-A1- 1 956 659
- WO-A1-02/31892
- WO-A1-2007/040065
- JP-A- 05 335 610
- JP-A- 06 204 541
- JP-A- 08 085 874
- JP-A- 08 085 874
- JP-A- 10 326 903
- JP-A- 10 326 903
- JP-A- 11 135 817
- JP-A- 11 317 475
- JP-A- 2006 146 027
- US-A- 5 656 098

## Description

### TECHNICAL FIELD

The present invention relates to a solar cell module including a photoelectric conversion body having an uneven surface on a light-entering surface.

### BACKGROUND ART

Generally, a solar cell module includes a photoelectric conversion body having a multi-layered structure with a pn junction or a pin junction formed by use of a crystalline semiconductor material such as single crystal silicon or polycrystalline silicon, an amorphous semiconductor material represented by amorphous silicon, or a compound semiconductor material such as GaAs and CuInSe. An electron-hole pair generated in the photoelectric conversion body by incident light is extracted to the outside through a pair of electrodes.

Moreover, it is known that a protection layer is formed on the photoelectric conversion body to protect the surface of this photoelectric conversion body and for other purposes (see, for example, Japanese Patent Publication No. 2002-335002). The protection layer thus formed can suppress damage in a surface portion of a photovoltaic element, and suppress deterioration of the photovoltaic element due to moisture, ultraviolet radiation, and the like.

On the other hand, the protection layer has a problem, for example, that a stress generated inside the protection layer warps the photovoltaic element. For this reason, it is desired that the protection layer be made of a material that causes less stress. As a way of decreasing a stress generated inside the protection layer, a method is disclosed in which minute particles are added to the protection layer (see, for example, Japanese Patent Publication No. 2000-261010). Additionally, a technique is proposed in which the concentration of minute particles in the protection layer is altered in the depth direction in order to suppress the reduction of adhesion caused by the addition of the minute particles (see, for example, Japanese Patent Publication No. 2756050).

EP-A-1956659 discloses a solar cell module with a photoelectric conversion body having an uneven surface covered by a resin protection layer. The protection layer thus has projected portions corresponding to outward protection of the uneven surface of the photoelectric conversion body and recessed portions corresponding to inward recesses in the uneven surface. In one embodiment, the projected portions of the projection layer are thinner than the processed portion.

In such a solar cell module having a photoelectric conversion body, which has an uneven surface called a texture on a light-receiving surface the uneven surface scatters incident light to increase an optical path length of light incident into the photoelectric conversion body. In this manner, the photoelectric conversion efficiency is improved.

The influences of stress and adhesion on a photovoltaic element having such a texture structure vary depending on the shape of the texture structure. Thus, it is desired to form a protection layer suitable for the texture structure.

According to the present invention there is provided a solar cell module comprising:
a photoelectric conversion body having an uneven surface on a light-entering surface;
   and
a protection layer made of a resin and provided to cover the uneven surface, the uneven surface being textured such that the protection layer has alternate projected portions and recessed portions, the projected portions projecting outwardly from the photoelectric conversion body and the recessed portions being recessed into the photoelectric conversion body, so that the surface of the protection layer furthest from the photoelectric conversion body is uneven, wherein
in a cross section of the protection layer taken in parallel to a light-entering direction, a thickness of a projected portion on the uneven surface is thinner than a thickness of a recessed portion on the uneven surface;
wherein:
   the amount of a hardener included in the recessed portion of the protection layer is smaller in a part at the photoelectric conversion body side than in a part at the light-entering side.

In the solar cell module according to the aspect of the present invention, the film thickness of the projected portion is thin. Accordingly, the stress at the projected portion can be decreased. Thereby, the warpage and peeling of the photovoltaic element occur in fewer occasions, and the weather resistance can be improved.

Moreover, in the solar cell module according to the aspect of the present invention, the protection layer preferably includes minute particles at least in the recessed portion, and the number of the minute particles included in the recessed portion of the protection layer is larger in a part at the photoelectric conversion body side than in a part at the light entering side.

In the solar cell module, a larger number of minute particles are placed in the bottom surface of the recessed portion of the protection layer. The bottom-surface layer of the recessed portion functions as a stress relaxation layer. The stress exerted on the photovoltaic element can be relaxed.

Moreover, in the solar cell module according to the aspect of the present invention, the amount of a hardener included in the recessed portion of the protection layer is smaller in a part at the photoelectric conversion body side than in a part at the light entering side.

In the solar cell module, a smaller amount of hardener is included in a part at the bottom surface of the recessed portion of the protection layer. Accordingly, the bottom-surface layer of the recessed portion functions as a stress relaxation layer, the stress exerted on the photovoltaic element can be relaxed.

Moreover, in the solar cell module according to the aspect of the present invention, the protection layer preferably includes minute particles, and in the cross section of the protection layer taken in parallel to the light-entering direction, a value obtained by dividing the number of minute particles included in a second region having unit length centered at the projected portion on the uneven surface by the second region is preferably smaller than a value obtained by dividing the number of minute particles included in a first region having unit length centered at the recessed portion on the uneven surface by an area of the first region.

In the solar cell module, a larger number of minute particles are placed in the recessed portion. Accordingly, the warp age of the photovoltaic element can be suppressed, and the reduction in the abrasion resistance at the projected portion can be suppressed.

Moreover, in the solar cell module according to the aspect of the present invention, the recessed portion of the protection layer preferably includes a pore in the resin forming the protection layer.

In the solar cell module, the pore serves as an air cushion, and the stress can be relaxed.

According to the present invention, it is possible to provide a solar cell module in which a photovoltaic element with a texture structure has a decreased internal stress in a protection layer and an improved weather resistance.

### BRIEF DESCRIPTION OF THE DRAWINGS

[Fig. 1] Fig. 1 is a schematic sectional view of a photovoltaic element according to an embodiment of the present invention.
[Fig. 2] Fig. 2 is a schematic sectional view of a light-receiving-surface-side protection layer in the photovoltaic element according to the embodiment of the present invention (No. 1).
[Fig. 3] Fig. 3 is a schematic sectional view of the light-receiving-surface-side protection layer in the photovoltaic element according to the embodiment of the present invention (No. 2).
[Fig. 4] Fig. 4 is a schematic sectional view of a solar cell module according to the embodiment of the present invention.
[Fig. 5] Fig. 5 is a drawing for describing problems in a conventional solar cell module.
[Fig. 6] Fig. 6 is a drawing for describing a coating method of a coating material in Examples of the present invention.

### BEST MODES FOR CARRYING OUT THE INVENTION

Hereinafter, embodiments of the present invention will be described with reference to the drawings. In the following description on the drawings, identical or similar components are denoted by identical or similar reference symbols. It should be noted, however, that the drawings are schematic, and that the dimensional proportions and the like are different from their actual values. Accordingly, specific dimensions and the like should be inferred on the basis of the description given below. Moreover, dimensional relationships and dimensional proportions may be different from one drawing to another in some parts.

### (Photovoltaic Element)

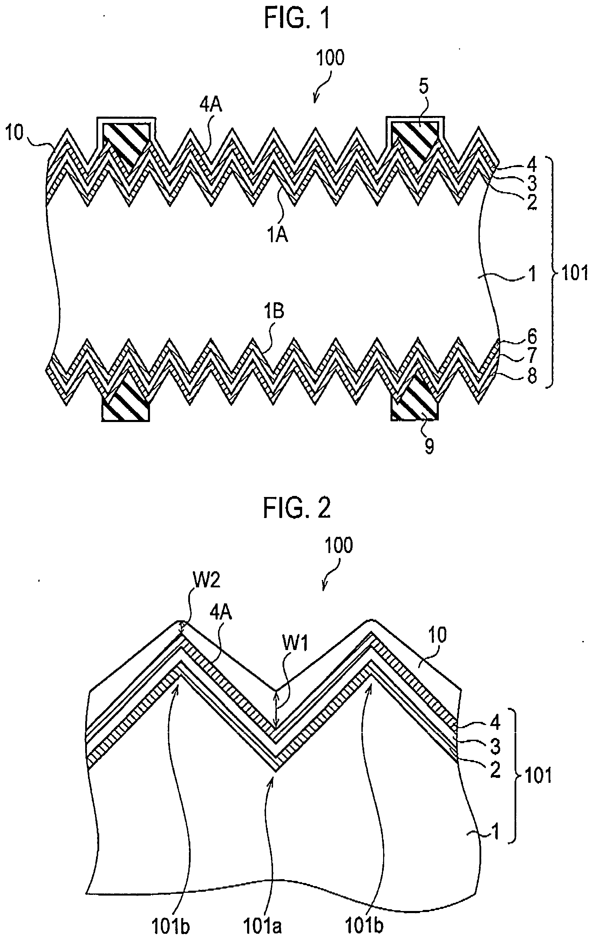

A photovoltaic element according to the embodiment of the present invention will be described with reference to Fig. 1 and Fig. 2.

Fig. 1 is a schematic sectional view for describing a structure of a photovoltaic element 100 according to the embodiment of the present invention. A substrate 1 is an n type single crystal silicon substrate, and has a texture surface on a light-receiving surface 1A. On the light-receiving surface 1A of the substrate 1, an i type amorphous silicon layer 2 having a thickness of approximately 10 nm, a p type amorphous silicon layer 3 having a thickness of approximately 10 nm, and a light-receiving-surface-side translucent electrode layer 4 made of ITO having a thickness of approximately 100 nm are stacked in this sequence. Light enters the photovoltaic element 100 from the light-receiving-surface-side translucent electrode layer 4. Since the substrate 1 has the texture surface on the light-receiving surface 1A, uneven surfaces are also formed on the light-receiving surfaces of the i type amorphous silicon layer 2, the p type amorphous silicon layer 3 and the light-receiving-surface-side translucent electrode layer 4, which are stacked on the light-receiving surface 1A, the uneven surfaces reflecting the shape of the texture surface formed on the light-receiving surface 1A of the substrate 1. Additionally, light-receiving-surface-side electrodes 5 for collecting currents are partially formed on the light-receiving surface of the light-receiving-surface-side translucent electrode layer 4, the light-receiving-surface-side electrodes 5 being made of a conductive paste such as an Ag paste.

A rear surface 1B of the substrate 1 being the single crystal silicon substrate has a texture surface. On the rear surface 1B, an i type amorphous silicon layer 6 having a thickness of approximately 10 nm, an n type amorphous silicon layer 7 having a thickness of approximately 10 nm, and a rear-surface-side translucent electrode layer 8 made of ITO having a thickness of approximately 100 nm are stacked in this sequence. Additionally, rear-surface-side electrodes 9 for collecting currents are partially formed on the surface of rear-surface-side translucent electrode layer 8, the rear-surface-side electrodes 9 being made of a conductive paste such as an Ag paste.

Furthermore, a photoelectric conversion body 101 is made of a laminated body of the light-receiving-surface-side translucent electrode layer 4, the p type amorphous silicon layer 3, the i type amorphous silicon layer 2, the n type single crystal silicon substrate 1, the i type amorphous silicon layer 6, the n type amorphous silicon layer 7 and the rear-surface-side translucent electrode layer 8. A light-receiving surface 4A of the light-receiving-surface-side translucent electrode layer 4 has an uneven surface, the light-receiving surface 4A as a light-receiving surface of the photoelectric conversion body 101.

A light-receiving-surface-side protection layer 10 is provided on the light-receiving surface 4A of the photoelectric conversion body 101 so as to cover the light-receiving surface 4A together with the surfaces of the light-receiving-surface-side electrodes 5.

Next, the structure of light-receiving-surface-side protection layer 10 in a solar cell according to the present embodiment will be described in detail with reference to Fig. 2. Fig. 2 is an enlarged schematic sectional view of a sectional structure of the light-receiving surface 4A and its vicinity of the photoelectric conversion body 101 in the photovoltaic element 100 shown in Fig. 1.

As shown in Fig. 2, the light-receiving surface 4A of the photoelectric conversion body 101 has the uneven surface, and the light-receiving-surface-side protection layer 10 is formed to cover the entire surface of the uneven surface. In a cross section of the light-receiving-surface-side protection layer 10 taken in parallel to the light-entering direction, a thickness W2 of a projected portion on the uneven surface is thinner than a thickness W1 of a recessed portion on the uneven surface.

Furthermore, the light-receiving-surface-side protection layer 10 may include a plurality of minute particles at least in the recessed portion. The number of the minute particles included in the recessed portion of the light-receiving-surface-side protection layer 10 is larger in a part at the photoelectric conversion body 101 side than in a part at the light receiving side.

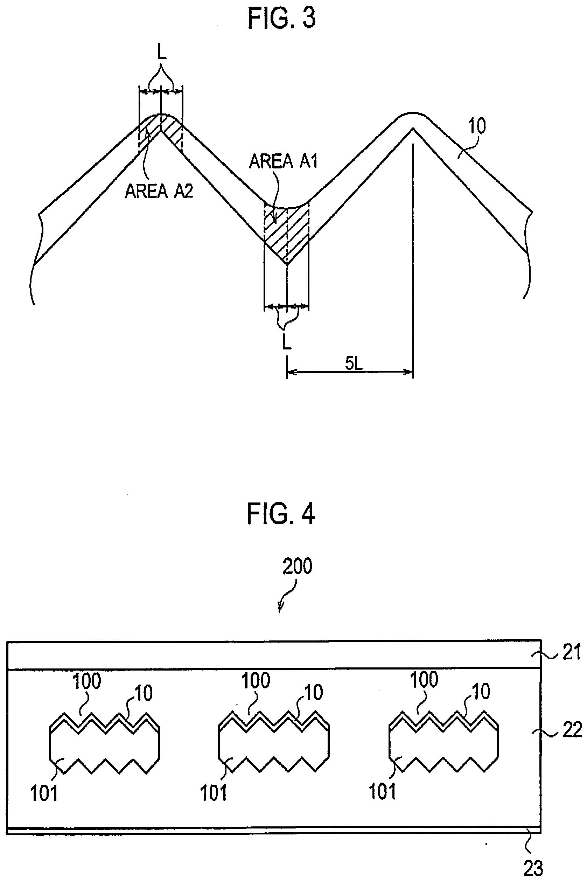

Alternatively, the light-receiving-surface-side protection layer 10 may include a plurality of minute particles throughout the inside thereof. In this case, a value obtained by dividing the number of minute particles included in a second region having unit length (L+L=2 L) centered at the projected portion on the uneven surface by an area A2 of the second region is smaller than a value obtained by dividing the number of minute particles included in a first region having unit length (L+L=2 L) centered at the recessed portion on the uneven surface by an area A1 of the first region, in the cross section of the light-receiving-surface-side protection layer 10 taken in parallel to the light-entering direction as shown in Fig. 3. Note that, herein, the length from the projected portion to the recessed portion is set to 5 L. Moreover, hereinafter, "number density" is defined as the value obtained by dividing the number of minute particles included in the region having unit length centered at the recessed portion or the projected portion by the area of the corresponding region.

As the minute particles placed inside the light-receiving-surface-side protection layer 10, particles having a comparatively smaller expansion coefficient than the expansion coefficient of the protection layer 10 are suited. As the material thereof, particles made of a translucent material such as ZnO, SiO₂, ITO, MgO, TiO₂ and Al₂O₃ can be used. Particularly, minute particles made of a metal oxide are preferably used, since such a metal oxide can suppress visible light absorption of the minute particles. Furthermore, the use of ZnO, TiO₂, or the like allows absorption of ultraviolet radiation, accordingly suppressing deterioration such as discoloration of the light-receiving-surface-side electrode 5 and the photoelectric conversion body 101 under the light-receiving-surface-side protection layer 10 due to ultraviolet radiation. As a result, the weather resistance can be further improved.

Furthermore, the size of the minute particles is preferably 10% or smaller of the film thickness of the light-receiving-surface-side protection layer 10. Particularly, the particle diameter of approximately 20 to 80 nm is further desirable, since light scattering effect can also be obtained.

Moreover, as a resin forming the light-receiving-surface-side protection layer 10, a translucent organic material such as an acrylic resin is used. Besides, a silicone resin, a fluororesin, or an epoxy resin may be used. Alternatively, a mixture of several resins may be used. In this respect, when a hardener is included into the resin, the amount of the hardener included in the recessed portion of the light-receiving-surface-side protection layer 10 is smaller in a part at the photoelectric conversion body 101 side than in a part at the light entering side.

Furthermore, the light-receiving-surface-side protection layer 10 may be formed by stacking resins having various viscosities so that the viscosity may vary within the light-receiving-surface-side protection layer 10. Moreover, in the recessed portion of the light-receiving-surface-side protection layer 10, the viscosity of the resin forming the protection layer is preferably smaller in a part at the photoelectric conversion body 101 side than in a part at the light entering side.

Furthermore, the resin forming the protection layer may include pores in the recessed portion of the light-receiving-surface-side protection layer 10.

### (Solar Cell Module)

Next, a solar cell module in which the above-described photovoltaic element is used will be described with reference to a sectional view shown in Fig. 4.

As shown in Fig. 4, a solar cell module 200 includes: the photovoltaic elements 100; a light-receiving-surface-side translucent member 21 placed to the light entering side of the photovoltaic elements 100; a rear-surface-side member 23 placed to the opposite side from the light entering side of the photovoltaic element 100; and a resin 22 placed between the light-receiving-surface-side translucent member 21 and the rear-surface-side member 23, the resin 22 sealing the photovoltaic elements 100. Each photovoltaic element 100 includes: the photoelectric conversion body 101 having the uneven surface on the light-receiving surface; and the light-receiving-surface-side protection layer 10 provided to cover the uneven surface.

The light-receiving-surface-side translucent member 21 is made of a translucent material such as a glass and a plastic. The rear-surface-side member 23 made of a member such as a metal, plastic, a resin film, and a glass. A plurality of photovoltaic elements 100 are electrically connected in series or parallel to each other by unillustrated wiring members, and are sealed in the translucent sealing resin layer 22 between the light-receiving-surface-side translucent member 21 and the rear-surface-side member 23.

### (Effects and Advantages)

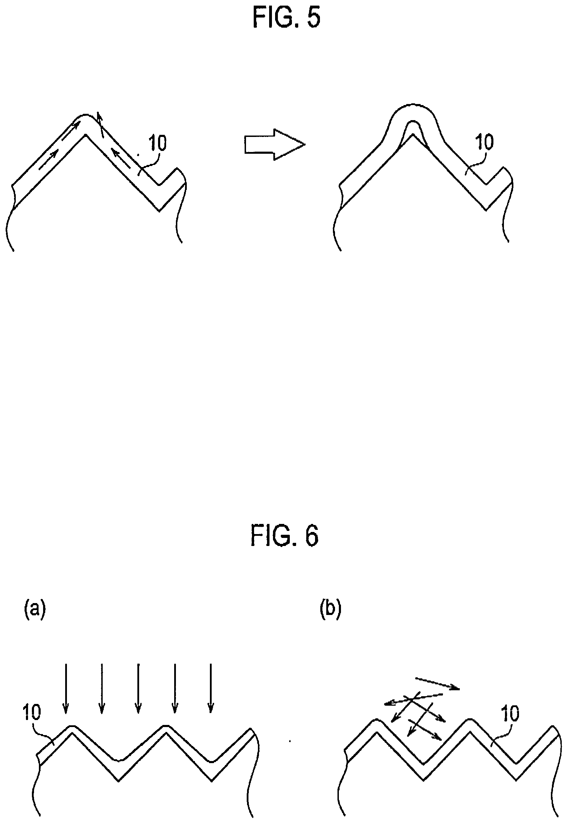

In the solar cell module according to the present embodiment, as shown in Fig. 2, the thickness W2 of the projected portion on the uneven surface is thinner than the thickness W1 of the recessed portion on the uneven surface in cross section of the light-receiving-surface-side protection layer 10 taken in parallel to the light-entering direction. If the recessed portion and the projected portion have the same thickness as in a conventional solar cell module, a stress in the protection layer due to expansion of the resin or other factors is generated upward along the interface with the photoelectric conversion body as shown in Fig. 5. Accordingly, the protection layer may peel off from the photoelectric conversion body at the projected portion. In the present embodiment, the film thickness of the projected portion is thin. This decreases the stress at the projected portion and thereby reduces the warpage and peeling of the photovoltaic element. As a result, the weather resistance can be improved.

Moreover, in the solar cell module according to the present embodiment, the light-receiving-surface-side protection layer 10 preferably includes the minute particles at least in the recessed portion, the number of the minute particles included in the recessed portion of the protection layer is larger in a part at the photoelectric conversion body 101 side than in a part at the light entering side. By placing a larger number of minute particles in the bottom surface of the recessed portion of the light-receiving-surface-side protection layer 10 in this manner, the bottom-surface layer of the recessed portion functions as a stress relaxation layer, and can relax the stress exerted on the photovoltaic element. Here, the minute particle has a comparatively smaller expansion coefficient than the expansion coefficient of the binder. Japanese Patent Publication No. Heisei 5-25324 and the like describe such minute particles.

Moreover, in the solar cell module according to the present embodiment, the amount of the hardener included in the recessed portion of the light-receiving-surface-side protection layer 10 is smaller in a part at the photoelectric conversion body side than in a part at the light entering side. By including less hardener in the bottom surface of the recessed portion of the light-receiving-surface-side protection layer 10 in this manner, the bottom-surface layer of the recessed portion functions as a stress relaxation layer, and can relax the stress exerted on the photovoltaic element.

Moreover, in the solar cell module according to the present embodiment, the viscosity of the resin forming the recessed portion of the light-receiving-surface-side protection layer 10 is preferably smaller in a part at the photoelectric conversion body side than in a part at the light entering side. By lowering the viscosity of the resin at the bottom surface of the recessed portion of the protection layer in this manner, the bottom-surface layer of the recessed portion functions as a stress relaxation layer, and can relax the stress exerted on the photovoltaic element.

Moreover, in the solar cell module according to the present embodiment, the light-receiving-surface-side protection layer 10 preferably includes the minute particles. In the cross section of the protection layer taken in parallel to the light-entering direction, a value obtained by dividing the number of minute particles included in the second region having unit length centered at the projected portion on the uneven surface by the second region is preferably smaller than a value obtained by dividing the number of minute particles included in the first region having unit length centered at the recessed portion on the uneven surface by the area of the first region. By placing the minute particles more in the recessed portion in this manner, the warpage of the photovoltaic element can be suppressed, and the reduction in the abrasion resistance at the projected portion can be suppressed. Note that abrasion resistance refers to tolerance of the projected portion to rubbing, for example, in carrying the solar cell module.

Furthermore, in the solar cell module according to the present embodiment, the recessed portion of the light-receiving-surface-side protection layer 10 preferably includes a pore in the resin forming the protection layer. By placing the pore in this manner, the pore serves as an air cushion, and can relax the stress.

### (Other Embodiments)

The present invention has been described on the basis of the aforementioned embodiment. However, the description and the drawings constituting parts of this disclosure are not construed to limit the invention. Various alternative embodiments, examples, and operation technologies will be obvious to those skilled in the art from this disclosure.

For example, although the structure of the photoelectric conversion body 101 shown in Fig. 2 has been described as the structure in the solar cell module according to the present embodiment, the structure of the photoelectric conversion body 101 is not limited to the one shown in Fig. 2. As the structure of the photoelectric conversion body, a well-known structure can be adapted. Examples of the well-known structure are: a structure including a pn junction therein by use of a crystalline semiconductor such as single crystal silicon or polycrystalline silicon solar cell; and a structure with a pin junction by use of a thin-film semiconductor such as amorphous silicon or micro-crystalline silicon.

Hence, it is obvious that the present invention includes various embodiments and the like not described herein. The technical scope of the present invention should only be defined by the claimed elements according to the scope of claims reasonably understood from the above description.

### EXAMPLES

Hereinafter, a thin-film solar cell module according to the present invention will be described specifically by way of Examples. The present invention, however, is not limited to the following Examples, and thus can be carried out by making appropriate changes without departing from the scope of the invention.

### (Method for Producing Solar Cell Module)

Hereinbelow, a method for producing a solar cell module according to Examples of the present invention will be described.

Anisotropic etching was conducted on the surface of an n type (100) single crystal silicon wafer having a specific resistance of approximately 1 Ω·m and a thickness of 300 pm, and a texture surface was formed. Then, the n type (100) single crystal silicon wafer was subjected to generally adapted cleaning to remove impurities. Subsequently, by using a known RF plasma CVD (13.56 MHz), at a forming temperature from 100 to 300°C, reaction pressure from 5 to 100 Pa, and RF power from 1 to 500 W/cm², i type and p type a-Si were deposited each by approximately 10 nm to produce a junction. As a p type dopant, B, Al, Ga, and In, which are Group 3 elements, are exemplified. A compound gas including at least one of these elements is mixed with a source gas such as SiH₄ to adjust the valence state into p type. In order to adjust the valence state to obtain an n type semiconductor, a compound gas including at least one of P, N, As, and Sb, which are Group 5 elements, is used. Beside the above method, a known method such as a vapor deposition method, a sputtering method, a RF plasma CVD method, a microwave plasma CVD method, an ECR method, a thermal CVD method, and an LPCVD method can be used for the hydrogenated amorphous Si. The semiconductor may be any one of Si, SiGe, SiGeC, SiN, SiGeN, SiSn, SiSnN, SiSnO, SiO, Ge, GeC, and GeN in crystalline form, amorphous form (containing at least one of hydrogen and fluorine), or micro-crystalline form.

Subsequently, an indium oxide thin film is deposited on the p type hydrogenated amorphous silicon. In the present examples, an Sn-doped indium oxide (hereinafter, referred to as ITO) was used as a translucent conductive film. Firstly, a sintered body of SnO₂ and In₂O₃ powders, in which the SnO₂ content was at 5 wt%, was placed as a target at a cathode. Other than Sn, at least one of Si, Ge, Ti, Mo, W, and Zn may be used as a dopant. The target should be produced by sintering the mixture of these compound powders of an appropriate amount with the indium oxide powders. By changing the amount of SnO₂, the Sn amount in the ITO can be changed. However, the amount of Sn relative to In is preferably 1 to 10 at%, and further preferably 2 to 7 at%. The sintered density of the target is preferably 90% or higher.

Subsequently, an Ag paste, in which silver (Ag) fine powder was kneaded into an epoxy resin, was formed by a screen-printing method to have a height of approximately 10 to 30 μm and width of 100 to 500 μm. Thereafter, the Ag paste was sintered and hardened at 200°C for 80 minutes to form bus bar electrodes which were to gather currents flowing through a comb-shaped collecting electrode and a comb-shaped electrode, which had a plurality of branch portions parallel to each other.

The photoelectric conversion body thus formed was coated with an inorganic material and an organic material such as an acrylic resin, a silicone resin, a fluororesin, and an epoxy resin, as a protection layer. Moreover, minute particles made of SiO₂ ZnO, TiO₂, or the like may be added to the protection layer. For the formation of the protection layer, a known protection-layer forming method such as a spray method and a roll coating method can be used. Meanwhile, a resin hardener is added to the protection layer.

### (Stress Evaluation)

In the present invention, the stress in the protection layer was focused on, and discussion has been made. Generally, addition of minute particles, mixing with a material having a low stress, and the like are known for stress relaxation. Thus, in order to examine actual stress relaxation effects, stresses of various protection layers were evaluated.

In this respect, it is difficult to directly measure the internal stress of a protection layer. Thus, the deformation rate of the protection layer was measured to measure the internal stress indirectly. In the experiment method, a PVF film cut into 10 cm x 1 cm with a thickness of 50 μm were coated with various protection layers, and then dried. Unless specifically stated otherwise, each protection layer had a thickness of approximately 2 pm. Moreover, the drying conditions were at 150°C for 20 minutes. At this point, the PVF is deformed in accordance with the stress in the protection layer, and accordingly the deformation rate in its length direction was used to evaluate the stress. Specifically, the deformation rate was measured when the temperature of the PVF changed from 150°C to normal temperature. The deformation rate is normalized while a contracted amount of the single PVF without any application is taken as 100%. In other words, the smaller value of normalized deformation rate indicates the lower internal stress. Table 1 shows this result.

**[Table 1]**

| Protection layer material | Normalized deformation rate |
|---|---|
| Acrylic (without hardener) | 400% |
| Acrylic (with hardener) | 466% |
| ZnO mixed acrylic (ZnO 75%: with hardener) | 200% |
| ZnO mixed acrylic (ZnO 75%: without hardener) | 133% |
| ZnO mixed acrylic (ZnO 67%: without hardener) | 167% |
| ZnO mixed acrylic (ZnO 60%: without hardener) | 333% |
| ZnO mixed acrylic (ZnO 75%: with hardener): film thickness 10 μm | 533% |
| Acrylic & low stress resin material (with hardener) | 200% |

ZnO mixed acrylic, in Table 1, indicates the inclusion of ZnO minute particles, and the numerical value indicates the content ratio relative to the resin forming the protection layer. For example, ZnO 75% means the inclusion of the ZnO particles at 75% by weight relative to the resin (before drying). Moreover, "with hardener" means the inclusion of a hardener in the resin forming the protection layer. An isocyanate prepolymer was used as the hardener. Furthermore, an acrylic & low stress resin material indicates a material used as the protection layer, in which an acrylic resin and a silicone resin are mixed at 1:1.

It was found out from Table 1 that the stress was decreased by mixing the ZnO minute particles, and that the stress was increased by including the hardener. Moreover, the following conventionally-known tendencies were also confirmed: larger film thickness increases the stress; the mixing of a resin having a low stress decreases the stress; and so on.

### (Experiment 1)

Protection layers including ZnO minute particles having a particle diameter of approximately 20 nm (ZnO content 75%) were formed on photoelectric conversion bodies by use of two types of sprays. Note that, here, the protection layers were formed only on the light entering sides. The material of the used protection layer had a low viscosity of approximately 1 cp. A spray A coats a target with the protection material in a form of shower at a high pressure, and thereby can form the protection layer in a manner that the protection layer is thick at a recessed portion and thin at a projected portion. A spray B coats a target with the protection material in a form of spiral, and thereby can form the protection layer with substantially uniform film thickness regardless of recessed and projected portions. Incidentally, the coating amount of protection material was adjusted, so that both sprays performed coating at approximately the same amount. The thicknesses of the protection layers are 0.5 μm or less as calculated from the coating weight.

Hereinbelow, the coating methods with the sprays A and B will be described in detail.

As shown in Fig. 6(a), with the spray A, a photoelectric conversion body is coated with a coating material from immediately above, and high pressure air is blown immediately above the photoelectric conversion body, the high pressure air being used to make the coating material in a form of mist. Accordingly, the applied coating material is pushed to flow downward by the high pressure air and the coating direction. Consequently, the protection layer is formed thin at the projected portion but thick at the recessed portion. On the other hand, as shown in Fig. 6(b), the spray B coats a photoelectric conversion body with a coating material in a swirling form. Moreover, high pressure air to make the coating material in a form of mist is blown also in a swirling form. Thereby, the force to push the coating material to flow downward is considerable small. Consequently, the protection layer has a substantially uniform film thickness.

Table 2 shows the result of weather resistance evaluation conducted on the structures formed by coating with use of these two sprays.

**[Table 2]**

| | Weather resistance |
|---|---|
| Spray A | 1.00 |
| Spray B | 0.96 |

Here, in the weather resistance evaluation, the module structure was formed, and a value used in this evaluation was obtained by dividing module output 2000 hours after the module was put into a high temperature-high humidity (85°C and 85%RH) furnace by module output before the module was put therein. Note that, in Table 2, the values were normalized with that obtained with the spray A being taken as 1. Moreover, the weather resistance evaluation for 2000 hours includes several cooling steps to decrease the temperature to room temperature for halfway evaluation. Furthermore, in this evaluation, a film on the back surface of the module was a PVF film in order to speedily check the weather resistance evaluation.

It was found out from Table 2 that higher weather resistance was obtained in the structure in which different film thicknesses were formed at the recessed and projected portions, respectively, than in the structure in which the protection layer was formed by substantially uniform coating. To put it differently, it was found out that higher weather resistance was obtained in the non-uniform structure formed by coating with use of the spray A than in the structure formed by coating with use of the spray B which is capable of uniformly applying a protection layer of a conventional structure. In this respect, samples after these weather resistance evaluations were put in a high temperature furnace of 120°C for 1 hour to check the appearance. As a result, in the case of the spray B, a larger number of protection-layer peeling incidents were observed particularly in a region of the projected portion.

In general, a stress is considered to be proportional to the intrinsic internal stress inside the film and to the film thickness. In this case, as the expansion coefficient is taken into consideration, the internal stress at the projected portion is expected to act in a direction in which the projected portion extends. When the force is exerted at the projected portion in such an extending direction, presumably a force is generated in such a direction that the protection layer is peeled off from the photoelectric conversion body. This is assumed to be the cause of the aforementioned peeling (see Fig. 5). At the recessed portion, meanwhile, presumably the protection layer expands in such a direction that the protection layer is pushed toward the photoelectric conversion body, and the peeling was hardly observed.

It is considered that the peeling at this projected portion (although the peeling was observed at the time of heating at 120°C in the above experiment, it is assumed that peeling which cannot be checked with naked eyes has occurred at the time of the weather resistance evaluation also) may serve as the entrance of moisture; thus, the difference in the weather resistance as shown in Table 2 has occurred. In other words, it is considered that, by forming the structure in which the film thickness is thin at the projected portion, a protection layer having an excellent weather resistance can be formed.

In this respect, the protection layer needs to have a certain film thickness. This is because the function as the protection layer is reduced in the thin-film structure. For this reason, the protection layer needs to be formed as thick as possible. In this case, however, the influence from the stress is increased, and the influences from the warpage and the like become stronger. In this experiment, in both sprays, the coating weights were approximately the same. However, in the case of the spray A, a thin film portion is formed at the projected portion, while a thick film portion is formed at the recessed portion. Because the function of the protection layer largely relies on the film thickness, the use of the spray A seems to be disadvantageous in a viewpoint of the weather resistance because of the thin film portion. However, in the overall sample, substantially equivalent weather resistance was obtained presumably because the protection layer is partially thicker than the protection layer formed by coating with use of the spray B. Actually, beside the protection performance, influence of the aforementioned peeling or the like was observed in the case of the spray B. As a result, it was found out that the spray A allowed to obtain higher weather resistance.

### (Experiment 2)

From the result obtained in Experiment 1, it was found out that the film thickness structure at the projected portion should be thin. On the other hand, it was also found out that, in order to maintain the weather resistance of the overall element, the film thickness structure at the recessed portion is desirably thick. For this reason, the influence of the stress at the recessed portion on the weather resistance was checked. With the spray A, a target was coated with a single acrylic layer having a comparatively large stress. As a result, it was found out that the warped photovoltaic element was observed after the target was coated with the acrylic layer and dried. The reason is considered as follows. With the spray A, the recessed portion had a comparatively thick film structure. The warpage was shown to be largely replying on the influence of the stress at the recessed portion. Particularly, when the protection layer expands at the recessed portion, the large force is exerted on the side surfaces of the recessed portion. This force is considered to be the cause of the warped element.

In other words, the decreasing of the stress at the recessed portion is considered to be important. For this reason, in order to relax the stress at the recessed portion, an attempt has been made to form a stress relaxation layer at the recessed portion. Specifically, in forming a protection layer, a film having a two-layered structure was formed with the spray A. The total film thickness of the two layers formed by coating was approximately 3 μm as calculated from the coating weight (a first coating layer was at approximately 1 μm, and a second coating layer was at approximately 2 μm). As the forming method of the stress relaxation layer, the following three factors were focused on while the result obtained from Table 1 was considered: addition of minute particles, no addition of a hardener, and mixing of a low-stress resin. Samples corresponding to these factors were formed. Tables 3 to 5 show the form of the protection layers produced in Experiment 2 and the weather resistance evaluation result.

**[Table 3]**

| | Protection layer structure | Weather resistance | Notes |
|---|---|---|---|
| Example 1 | Acrylic layer | 1.00 | With warpage |
| Example 2 | Acrylic ZnO layer/acrylic layer | 1.07 | |

**[Table 4]**

| | Protection layer structure | Weather resistance |
|---|---|---|
| Example 3 | Acrylic ZnO layer (with hardener) | 1.00 |
| Example 4 | Acrylic ZnO layer (without hardener)/acrylic layer ZnO (with hardener) | 1.02 |

**[Table 5]**

| | Protection layer structure | Weather resistance |
|---|---|---|
| Example 5 | Acrylic ZnO layer | 1.00 |
| Example 6 | Acrylic & low viscosity resin ZnO layer /acrylic ZnO layer | 1.03 |

Note that, in each of Tables 3 to 5, a protection layer in which no stress relaxation layer is formed has a single-layered structure (hereinafter, referred to as a reference), the stress relaxation layer serving as an indicator of this weather resistance evaluation. However, in order to share the identical conditions, the reference was coated with the coating material twice as similar to a multi-structure in which a stress relaxation layer is formed. Note that the weather resistance is normalized with that of the reference structure taken as 1. Moreover, in the structure of the protection layer in this experiment, the film thickness of the recessed portion is thick in comparison with the projected portion as in (Experiment 1. The misting pressure for the first layer was set particularly high. Thereby, a next-coating material was formed in a way that substantially a single layer was formed at the projected portion in each structure.

In addition, an acrylic ZnO layer, in Examples 2 to 6, indicates the inclusion of ZnO minute particles at 75% by weight in the resin (before drying). Furthermore, an acrylic & low viscosity resin ZnO layer in Example 6 indicates that an acrylic resin and a silicone resin are mixed at 1:1 as the protection layer, and that ZnO minute particles are included at 75% by weight. Moreover, in Examples 2, 4 and 6, two kinds of protection layers are listed. The precedingly-listed layer is a lower layer, while the later-listed layer is an upper layer. For example, in the protection layer of Example 2, an acrylic layer was formed on an acrylic ZnO layer.

It is recognized from the results of Tables 3 to 5 that the weather resistance was excellent in a structure in which a film having a low stress was provided as the foundation layer at the recessed portion. To be specific, it was found out that the weather resistance was improved by providing the stress relaxation layer at the recessed portion of the protection layer, the stress relaxation layer being for example: a layer to which the ZnO minute particles were added (Example 2); a layer to which no hardener for increasing a stress was added (Example 4); or a layer in which a low stress resin is mixed (Example 6). Moreover, warpage was observed in Table 3. It is considered that this warpage caused a crack and the like in the photovoltaic element and lowered the weather resistance. In the experiments shown in Table 4 and Table 5, no warpage was observed with naked eyes, but it is assumed that small warpage had repeatedly occurred due to the long-term weather resistance evaluation, the change in temperature at the time of evaluation, and so forth. Consequently, the difference in the weather resistance presumably occurred. In this manner, it was found out that high weather resistance is obtained by the structure in which the stress relaxation layer is provided at the recessed portion.

To put it differently, although the film thickness of the projected portion is desirably thin as discussed in Experiment 1, it is desired to form a comparatively thick protection layer at the recessed portion rather than forming a uniform film, when the protection performance for the photoelectric conversion body is taken into consideration. However, in this case, although peeling of the protection layer due to the stress is not a large issue, warpage of the element is concerned. This warpage serves as a factor of a crack occurrence; consequently, the reduction in the weather resistance is observed. For this reason, regardless of thickness, a layer capable of relaxing the stress is desirably formed at the recessed portion.

### (Experiment 3)

In the structure of Experiment 2, the stress relaxation layer was provided. Meanwhile, in Experiment 3, evaluation was made on a structure in which a stress relaxation member was disposed in the entire recessed portion in order to relax a stress at the recessed portion. Here, the used stress relaxation member had a structure coated with ZnO minute particles. By setting a high misting pressure of the spray A, two kinds of protection layers were formed: one with the ZnO minute particles added, and the other without the ZnO minute particles. The protection layer to which the ZnO minute particles were added has a smaller number density at the projected portion than at the recessed portion. Meanwhile, the coated film thickness was approximately 3 μm as calculated from the coating amount. Table 6 shows the protection layer structure produced in Experiment 3 and the weather resistance evaluation result.

**[Table 6]**

| | Protection layer structure | Weather resistance | Notes |
|---|---|---|---|
| Example 7 | Acrylic layer (with hardener) | 1.00 | With warpage |
| Example 8 | ZnO mixed acrylic layer (with hardener) | 1.08 | |

Note that, in Table 6, the weather resistance is normalized with that of a protection layer formed of only an acrylic resin taken as 1. In the structure of the protection layer in this experiment, the film thickness of the recessed portion is thick in comparison with the projected portion as in Experiment 1. Moreover, it was checked from the result of TEM observation that ZnO particles were hardly included in the projected portion. In other words, it was checked that the projected portion and the recessed portion of the protection layer formed in Experiment 3 had structures different in the ZnO minute particle concentration.

It was found out from Examples 7 and 8 shown in Table 6 that the protection layer including a film mixed with the ZnO minute particles had a higher weather resistance than the single acrylic layer. To put it differently, the high weather resistance was presumably obtained in the structure in which the ZnO minute particles were mixed in the recessed portion to decrease the internal stress. This is considered to be caused by a factor different from that caused the peeling in Experiment 1. In Example 7, warpage in the sample was observed with naked eyes immediately after coating. In other words, the warpage due to the stress influences the weather resistance result. This is considered that the warpage of the photovoltaic element caused a crack inside the photovoltaic element, the peeling at the junction portion, and the like, and that thereby the long-term reliability was deteriorated. As a result, the difference in the weather resistance shown in Table 6 occurred.

In this respect, as described above, the recessed portion and the projected portion are different in the number density of ZnO. Here, L represents one of five parts obtained by equably dividing the distance between the recessed portion and the projected portion in the texture structure as shown in Fig. 3. The range of two Ls centered at the apex of the recessed portion or the projected portion is defined as a region where the recessed portion or the projected portion is located. The number of minute particles in a layer included in that range is counted. The number density was obtained by dividing the number of minute particles by the area of the range.

It was found out that the abrasion resistance was improved in the structure in which the recessed portion had a small number density and the projected portion had a large number density. In general, when a binder includes minute particles, a large amount of the minute particles exist at the contact interface with the element. The adhesion between the element and the protection layer is influenced largely by the contact area between the binder and the element. Accordingly, as the amount of the minute particles is increased, the adhesion is decreased. By including the minute particles in the protection layer, the stress, thermal expansion, and the like are reduced. For this reason, the influence of the decreased adhesion due to the added minute particles is presumably made comparatively small. However, the influence of the adhesion is large for the peeling by a mechanical force such as rubbing. In this case, the abrasion resistance causes a large load on the projected portion. Thus, in the element having a projected portion with a decreased adhesion, the abrasion resistance is reduced. Particularly, when the minute particles are added in order to decrease the stress at the recessed portion, the reduction in the abrasion resistance must be taken into account in the structure in which a large amount of the minute particles are included in a projected portion. For this reason, it is more desirable to reduce the number density of the minute particles at the projected portion by, for example, setting a high misting pressure, as obtained in Experiment 3.

### (Experiment 4)

In Experiment 4, a way to introduce pores in the protection layer was examined in order to relax the stress. Here, by a spray method and a roll coating method, a target was coated with an acrylic layer including ZnO minute particles. In the roll coating method, a film is formed by pushing the protection member from the upper part. Accordingly, the pushing pressure is comparatively weak at the recessed portion, and the pores can be formed at the recessed portion by forming the films multiple times. Table 7 shows the weather resistance evaluation result of these samples. In this respect, the weather resistance is normalized with that of the sample with the spray method taken as 1. Note that the pores described here are comparatively large, so that at least the long diameter is 1 μm or longer.

**[Table 7]**

| | Weather resistance | Notes |
|---|---|---|
| Spray method | 1.00 | - |
| Roll coating method | 1.02 | Including pores at recessed portion |

It was found out from Table 7 that the sample with the roll coating method had the higher weather resistance. This is considered that the existence of the pores influenced greatly. In other words, this is a result of the pores that served as a buffer to relax the stress. Thus, it was found out that the weather resistance is improved also by forming a layer including pores serving as the stress relaxation layer.

### INDUSTRIAL APPLICABILITY

As has been described, the present invention can provide a solar cell module in which a photovoltaic element with a texture structure has a decreased internal stress in a protection layer and an improved weather resistance. Therefore, the solar cell module is useful in solar power generation.

## Claims

1. A solar cell module comprising:
a photoelectric conversion body (101) having an uneven surface on a light-entering surface; and
a protection layer (10) made of a resin and provided to cover the uneven surface,
the uneven surface being textured such that the protection layer (10) has alternate projected portions and recessed portions, the projected portions projecting outwardly from the photoelectric conversion body (101) and the recessed portions being recessed into the photoelectric conversion body (101), so that the surface of the protection layer (10) furthest from the photoelectric conversion body (101) is uneven, wherein a thickness (W2) of a projected portion of the protection layer (10) is thinner than a thickness (W1) of a recessed portion of the protection layer (10);
**characterised in that**:
the amount of a hardener included in the recessed portion of the protection layer (10) is smaller in a part at the photoelectric conversion body side than in a part at the light-entering side.

2. The solar cell module according to claim 1, wherein the recessed portion of the protection layer (10) includes a pore in the resin forming the protection layer.

## Patentansprüche

1. Solarzellenmodul, umfassend:
einen fotoelektrischen Umwandlungskörper (101) mit einer unebenen Oberfläche auf einer Lichteintrittsoberfläche; und
eine Schutzschicht (10), die aus einem Harz hergestellt und bereitgestellt ist, um die unebene Oberfläche zu bedecken, wobei
die unebene Oberfläche derart strukturiert ist, dass die Schutzschicht (10) abwechselnd Vorsprungs- und Vertiefungsabschnitte aufweist, wobei die Vorsprungs-abschnitte vom fotoelektrischen Umwandlungskörper (101) weg abstehen und die Vertiefungsabschnitte im fotoelektrischen Umwandlungskörper (101) vertieft angeordnet sind, sodass die Oberfläche der Schutzschicht (10), die am weitesten vom fotoelektrischen Umwandlungskörper (101) entfernt ist, uneben ist, wobei
eine Dicke (W2) eines Vorsprungsabschnitts der Schutzschicht (10) dünner ist als eine Dicke (W1) eines Vertiefungsabschnitts der Schutzschicht (10);
**dadurch gekennzeichnet, dass**:
die Menge eines Härtungsmittels, das im Vertiefungsabschnitt der Schutzschicht (10) umfasst ist, in einem Teil auf der fotoelektrischen Umwandlungskörperseite geringer ist als in einem Teil auf der Lichteintrittsseite.

2. Solarzellenmodul nach Anspruch 1, wobei der Vertiefungsabschnitt der Schutzschicht (10) im Harz, das die Schutzschicht ausbildet, Poren umfasst.

## Revendications

1. Module de pile solaire, comprenant :
un corps de conversion photoélectrique (101) ayant une surface irrégulière sur une surface d'entrée de lumière entrante ; et
une couche de protection (10) constituée d'une résine et prévue pour couvrir la surface irrégulière,
la surface irrégulière étant texturée de telle sorte que la couche de protection (10) a des parties en saillie et des parties en creux alternées, les parties en saillie faisant saillie vers l'extérieur à partir du corps de conversion photoélectrique (101) et les parties en creux étant en retrait dans le corps de conversion photoélectrique (101), de sorte que la surface de la couche de protection (10) la plus éloignée du corps de conversion photoélectrique (101) est irrégulière, dans lequel,
une épaisseur (W2) d'une partie en saillie de la couche de protection (10) est plus mince qu'un épaisseur (W1) d'une partie en creux de la couche de protection (10) ;
**caractérisé en ce que** :
la quantité d'un agent de durcissement inclus dans la partie en creux de la couche de protection (10) est plus mince dans une partie du côté du corps de conversion photo-électrique que dans une partie du côté d'entrée de lumière.

2. Module de pile solaire selon la revendication 1, dans lequel la partie en creux de la couche de protection (10) comprend un pore dans la résine formant la couche de protection.
